# EUROPÄISCHE PATENTSCHRIFT

(11) **EP 1 468 433 B1**
(45) Veröffentlichungstag und Bekanntmachung des Hinweises auf die Patenterteilung: **20.07.2005**
(21) Anmeldenummer: 03712058.1
(22) Anmeldetag: 19.03.2003
(51) Int. Cl.: H01F 41/04, H01F 17/00, H01L 21/02

(54) **SPULE AUF EINEM HALBLEITERSUBSTRAT UND VERFAHREN ZU DEREN HERSTELLUNG**
COIL ON A SEMICONDUCTOR SUBSTRATE AND METHOD FOR PRODUCTION THEREOF
BOBINE SUR UN SUBSTRAT SEMICONDUCTEUR ET PROCEDE DE FABRICATION ASSOCIE

(30) Priorität: 21.03.2002 DE 10212630
(43) Veröffentlichungstag der Anmeldung: 20.10.2004
(73) Patentinhaber: Infineon Technologies AG, 81669 München (DE)
(72) Erfinder: BUEYUEKTAS, Kevni, 80807 München (DE); KOLLER, Klaus, 82110 Germering (DE); MUELLER, Karlheinz, Velden 84149 (DE)
(74) Vertreter: Zimmermann, Tankred Klaus
(86) Internationale Anmeldenummer: PCT/EP2003/002880
(87) Internationale Veröffentlichungsnummer: WO 2003/081616

(56) Entgegenhaltungen:
- EP-A- 1 039 544
- US-A- 6 140 197
- US-A1- 2001 016 409
- US-A1- 2001 028 098
- US-A1- 2002 008 301
- US-B1- 6 180 995

## Beschreibung

Die vorliegende Erfindung bezieht sich auf eine Spule an einem Halbleitersubstrat, insbesondere auf eine Spule mit hoher Güte sowie auf ein Verfahren zum Herstellen derselben.

Viele integrierte Halbleiterbausteine bzw. Halbleiterchips enthalten Spulen. Bei der Herstellung eines Halbleiterbausteins wird an einer Oberfläche eines Siliziumsubstrats eine Bauelementschicht erzeugt, die eine Mehrzahl von Dioden, Transistoren oder anderen Halbleiterbauelementen aufweist. Über der Bauelementschicht werden mehrere Verdrahtungsschichten erzeugt, die metallische Verdrahtungsleiterbahnen zur Verdrahtung der Bauelemente aufweisen und darüber hinaus Kondensatoren, Spulen etc. enthalten können. Zwischen den Verdrahtungsschichten sind elektrisch isolierende IntermetallDielektrikumschichten zu elektrischen Isolierung der Verdrahtungsleiterbahnen angeordnet. Spulen werden in oder auf den Verdrahtungsschichten in Form von spiralförmigen Leiterbahnen erzeugt, die mehrere Spiralwindungen und verschiedene Geometrien aufweisen können, wobei die Enden der Spule als Eingang und Ausgang elektrisch kontaktiert werden. Das Material der Spulenleiterbahn kann wie auch das Material der Verdrahtungsleiterbahnen Aluminium, Aluminiumlegierungen, Kupfer oder andere leitfähige Materialien, insbesondere Metalle, aufweisen.

Besonders bei Hochfrequenzanwendungen ist die Güte einer der wichtigsten Parameter einer Spule und sollte möglichst hoch sein. Die Spulengüte wird durch alle Leistungsverluste der Spule bestimmt, d. h. unter anderem durch den elektrischen Widerstand der Spulenleiterbahn, so daß durch die Wahl des Materials der Spulenleiterbahn bzw. der die Spule bildenden leitfähigen Schicht die Spulengüte beeinflußt werden kann. Ferner wird die Güte einer Spule wesentlich von einer Kopplung der Spule an umgebende Materie beeinflußt. Um Hochfrequenzspulen mit hoher Güte zu erzeugen, wird deshalb allgemein versucht, diese durch Substratankopplung hervorgerufenen Verluste zu verringern.

Eine Möglichkeit, die Spulengüte zu verbessern, besteht darin, bei Verwendung eines Siliziumsubstrats durch die Wahl der Dotierung des Siliziumsubstrats die Verluste zu reduzieren bzw. zu minimieren. Die Dotierung des Siliziumsubstrats kann jedoch in vielen Fällen nicht frei gewählt werden, da sie in der Regel gleichzeitig mit weiteren Eigenschaften des Siliziumsubstrats, beispielsweise mit seiner Eignung für bestimmte Bauelemente oder Anordnungen von Bauelementen, verknüpft ist.

Eine weitere Möglichkeit der Verbesserung der Spulengüte besteht darin, zwischen der Spule und dem Substrat eine Abschirmung einzubauen. Dies ist jedoch in der Regel aufwendig und mit erheblichen Mehrkosten in der Herstellung verbunden und deshalb für viele Anwendungen nicht geeignet.

Hinzu kommt, daß sowohl durch die Wahl der Dotierung des Siliziumsubstrats als auch durch einen Einbau einer Abschirmung nur eine geringfügige Verbesserung der Spulengüte erreicht werden kann.

Eine weitere Möglichkeit besteht darin, das Siliziumsubstrat unter der Spule zu entfernen. Auch dies erfordert jedoch aufwendige und kostenintensive zusätzliche Schritte im Herstellungsprozeß.

Die US 2001/0016409 A1 beschreibt ein induktives Element mit einer hohen Güte Q. Das induktive Element ist aus Leitern 2zusammengesetzt, die über einem in Isolierschichten gebildeten Hohlraum angeordnet und durch Stützstrukturen gehalten werden. Der Hohlraum ist mit Parylene C, Polyimide, einem Schaum oder Luft gefullt. Die Stützstrukturen gehen beim Bilden des Hohlraums durch Ätzen aus den Isolierschichten hervor.

Die EP 1039544 A1 beschreibt eine monolithisch integrierte Schaltung mit einem Induktor. Der Induktor weist Kupferwindungen auf, die auf einer Siliziumoxidschicht angeordnet sind. Zwischen der Siliziumoxidschicht und einer gegenüberliegenden Passivierungsschicht ist ein Hohlraum angeordnet. Auf den Kupferwindungen ist eine Goldschicht vorgesehen.

Die US 2002/0008301 A1 beschreibt ein monolithisches Induktanz-Bauelement mit hoher Güte Q. In einem Bereich unterhalb einer Spule, die aus einem Stapel paralleler spiralförmiger leitfähiger Leitungen gebildet ist, ist eine erste Isolierschicht durch eine zweite Isolierschicht mit einer niedrigeren Dielektrizitätskonstante ersetzt.

Die US 6,140,197 A beschreibt einen spiralförmigen Hochfrequenz-Induktor mit einer hohen Güte Q. Zunächst werden in einer Intermetalldielektrikumschicht Öffnungen erzeugt, die dann durch eine dünne Oxidschicht verschlossen werden. Auf der dünnen Oxidschicht wird der Induktor erzeugt.

Die US 6,180,995 B1 beschreibt ein integriertes passives Bauelement mit einer reduzierten parasitären Kapazität zum Substrat. Ein metallischer spiralförmiger Induktor oder ein Kondensator ist über einem Luftspalt in einer epitaktischen Schicht angeordnet. Über der epitaktischen Schicht wird zunächst eine Feldoxidschicht gebildet und mit einer Mehrzahl von Öffnungen versehen. Mittels eines isotrop wirkenden Ätzmediums wird unter den Öffnungen in der Feldoxidschicht der Luftspalt erzeugt. Durch konformes Abscheiden eines Oxids werden die Öffnungen in der Feldoxidschicht verschlossen, bevor die induktive Spirale gebildet wird. Alternativ werden auf der Feldoxidschicht Metalleitungen gebildet bevor Öffnungen und ein Luftspalt erzeugt werden.

Die US 2001/0028098 A1 beschreibt einen Induktor mit einer hohen Güte Q. Nach dem Bilden einer Spule aus spiralförmigen Metalleitungen werden zwischen diesen spiralförmige Gräben erzeugt.

Die US 6,287,931 B1 beschreibt ein Verfahren zum Herstellen eines On-Chip-Induktors. In einem Halbleitersubstrat wird ein Graben gebildet und mit einer isolierenden Schicht gefüllt, die eine geringere relative Permittivität aufweist als Siliziumoxid. Über dem Graben bzw. der diesen füllenden isolierenden Schicht wird eine spiralförmige leitfähige Spule gebildet.

Die Aufgabe der vorliegenden Erfindung besteht darin, eine einfachere Spuleneinrichtung mit einer hohen Güte bzw. ein vereinfachtes Verfahren zur Herstellung einer Spule mit einer hohen Güte zu schaffen.

Diese Aufgabe wird durch eine Spuleneinrichtung gemäß Anspruch 1 bzw. ein Verfahren gemäß Anspruch 7 gelöst.

Eine Spuleneinrichtung gemäß der vorliegenden Erfindung umfaßt eine Spulenleiterbahn, ein Halbleitersubstrat und eine auf dem Halbleitersubstrat angeordnete Dielektrikumschicht, wobei zumindest Teile der Spulenleiterbahn über einer Ausnehmung in der Dielektrikumschicht angeordnet sind.

Ein Verfahren zum Herstellen einer Spule an einem Halbleitersubstrat umfaßt einen Schritt des Erzeugens einer Dielektrikumschicht auf dem Halbleitersubstrat, einen Schritt des Erzeugens einer Spulenleiterbahn auf der Dielektrikumschicht und einen Schritt des Erzeugens einer Ausnehmung in der Dielektrikumschicht zwischen der Spulenleiterbahn und dem Halbleitersubstrat.

Der vorliegenden Erfindung liegt die Erkenntnis zugrunde, daß unter der Spule liegende Dielektrikumschichten großen Einfluß auf die Kopplung einer Spule an umgebende Materie und damit auf ihre Güte haben. Über parasitäre Kapazitäten werden Ströme im Halbleitersubstrat induziert, die eine ohmsche Heizung des Substrats bewirken und so dem elektromagnetischen Wechselfeld der Spule Leistung entziehen. Je geringer die Kopplung der Spule an das Substrat ist, desto geringer ist folglich die durch die Spule im Substrat deponierte Verlustleistung und desto höher ist die Güte der Spule. Durch gezieltes Entfernen von isolierenden Schichten unterhalb der Spule kann dort eine Permittivitätszahl nahe 1, d. h. entsprechend der von Luft, erzielt werden.

Die parasitären Kapazitäten werden vor allem durch die Dielektrikumschichten bestimmt, die meist eine Dielektrizitätskonstante (DK) bzw. Permittivitätszahl εᵣ deutlich über 2 aufweisen. Bei Verwendung von oxidischen Schichten, die durch plasmaunterstützte Gasphasenabscheidung hergestellt werden, liegt εᵣ zwischen 3 und 4. Eine Verbesserung der Spulengüte ist deshalb auch durch Verwendung von organischen Materialien mit einer geringeren Permittivitätszahl εᵣ in den Dielektrikumschichten erzielbar.

Aufgrund der Ausnehmung ist bei der erfindungsgemäßen Spuleneinrichtung bzw. bei der erfindungsgemäß hergestellten Spule die elektromagnetische Kopplung zwischen der Spule und dem Substrat wesentlich verringert, woraus geringere Substratverluste und eine verbesserte Spulengüte folgen. Bei ersten Messungen wurde eine Verbesserung der Spulengüte um bis zu 100 % festgestellt.

Ein weiterer Vorteil der vorliegenden Erfindung besteht darin, daß die Spuleneinrichtung kostengünstig und effizient mit Standardprozessen der Halbleiterfertigung hergestellt werden kann bzw. daß das erfindungsgemäße Herstellungsverfahren mit Standardprozessen durchführbar ist und deshalb einfach und leicht in eine Halbleiterfertigung integrierbar ist.

Ein weiterer Vorteil besteht darin, daß aufgrund der deutlich reduzierten parasitären Kapazitäten der Resonanzschwingungsfrequenzbereich angehoben werden kann. Dadurch erweitert sich das Spektrum der Einsatzmöglichkeiten einer erfindungsgemäßen Spuleneinrichtung bzw. einer erfindungsgemäß hergestellten Spule gegenüber einer herkömmlichen Spule in erheblichem Maße. Zusätzlich ergibt sich für den Bereich der Güte Q ein um einen Faktor 2 breitbandigerer Frequenzbereich (Plateau in der Frequenzabhängigkeit der Güte).

Eine besonders bevorzugte Anwendung findet die Erfindung.in Zusammenhang mit hochintegrierten Bipolar-, BiCMOS- oder CMOS- Prozessen.

Ein weiterer Vorteil der vorliegenden Erfindung besteht darin, daß sie aufgrund der beschriebenen Verbesserungen bereits bestehenden Spulendesigns bzw. Spulenbauarten einen wesentlich breiteren Einsatzbereich eröffnet, ohne zusätzliche Anpassungen von Layout oder Materialeigenschaften zu erfordern.

Bevorzugte Weiterbildungen der vorliegenden Erfindung werden in den Unteransprüchen definiert.

Bevorzugte Ausführungsbeispiele der vorliegenden Erfindung werden nachfolgend mit Bezug auf die beiliegenden Zeichnungen näher erläutert. Es zeigen:
- Fig. 1: eine schematische Draufsicht auf eine Spulenleiterbahn einer Spuleneinrichtung gemäß einem ersten bevorzugten Ausführungsbeispielen der vorliegenden Erfindung;
- Fig. 2A bis 2C: schematische Schnittdarstellungen der Spule aus Fig. 1;
- Fig. 3: eine schematische Draufsicht auf eine Spulenleiterbahn einer Spuleneinrichtung gemäß einem zweiten bevorzugten Ausführungsbeispiel der vorliegenden Erfindung;
- Fig. 4: eine schematische Schnittdarstellung der Spule aus Fig. 3;
- Fig. 5A: eine schematische Schnittdarstellung einer Spule gemäß einem dritten Ausführungsbeispiel der vorliegenden Erfindung;
- Fib. 5B: eine schematische Schnittdarstellung einer Spule gemäß einem vierten Ausführungsbeispiel der vorliegenden Erfindung;
- Fig. 6: eine schematische Darstellung des erfindungsgemäßen Herstellungsverfahrens in einem Flußdiagramm; und
- Fig. 7: eine schematische Darstellung der Resonanzschwingungsfrequenzbereiche einer erfindungsgemäßen Spule und einer herkömmlichen Spule.

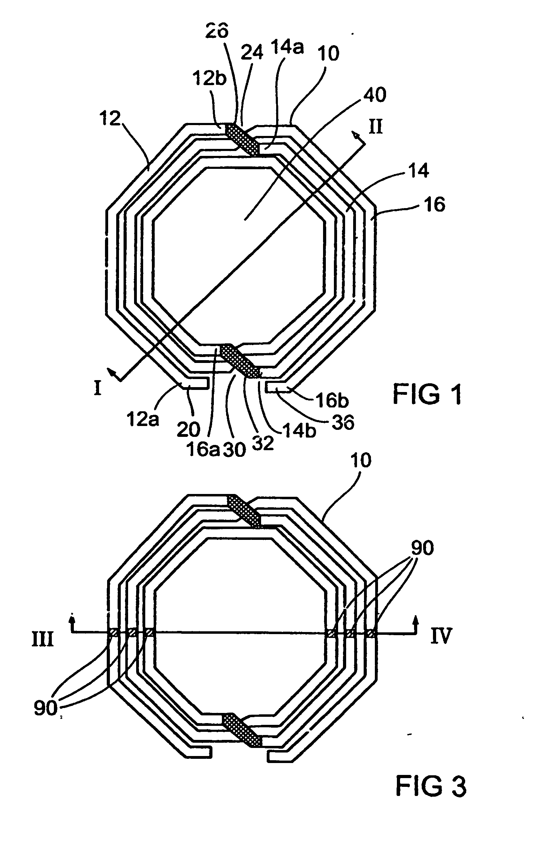

Fig. 1 ist eine schematische Draufsicht einer Spule gemäß einem ersten Ausführungsbeispiel der vorliegenden Erfindung. Die Spule wird durch eine Spulenleiterbahn 10 mit mehreren Abschnitten 12, 14, 16, die näherungsweise in Form von Teilabschnitten regelmäßiger Achtecke konzentrisch zueinander angeordnet sind, gebildet. Der erste Abschnitt 12 der Spulenleiterbahn 10 umfaßt an einem ersten Ende 12a einen ersten Kontaktierbereich 20. Ein zweites Ende 12b des ersten Abschnitts ist in einem ersten Kreuzungsbereich 24 über ein erstes Verbindungsstück 26 mit einem ersten Ende 14a des zweiten Abschnitts elektrisch leitfähig verbunden, wobei das erste Verbindungsstück 26 den dritten Abschnitt 16 kreuzt und von diesem durch eine nicht dargestellte Isolierschicht elektrisch isoliert ist. In einem zweiten Kreuzungsbereich 30 ist ein zweites Ende 14b des zweiten Abschnitts 14 über ein zweites Verbindungsstück 32 mit einem ersten Ende 16a des dritten Abschnitts 16 elektrisch leitfähig verbunden, wobei das zweite Verbindungsstück 32 den dritten Abschnitt 16 kreuzt und von diesem durch eine nicht dargestellte Isolierschicht elektrisch isoliert ist. Ein zweites Ende 16b des dritten Abschnitts 16 ist als ein zweiter Kontaktierbereich 36 ausgebildet. Der erste Abschnitt 12, das erste Verbindungsstück 26, der zweite Abschnitt 14, das zweite Verbindungsstück 32 und der dritte Abschnitt 16 bilden zusammen die Spulenleiterbahn 10, die in drei Windungen um das Innere.40 der Spulenleiterbahn 10 gewunden ist.

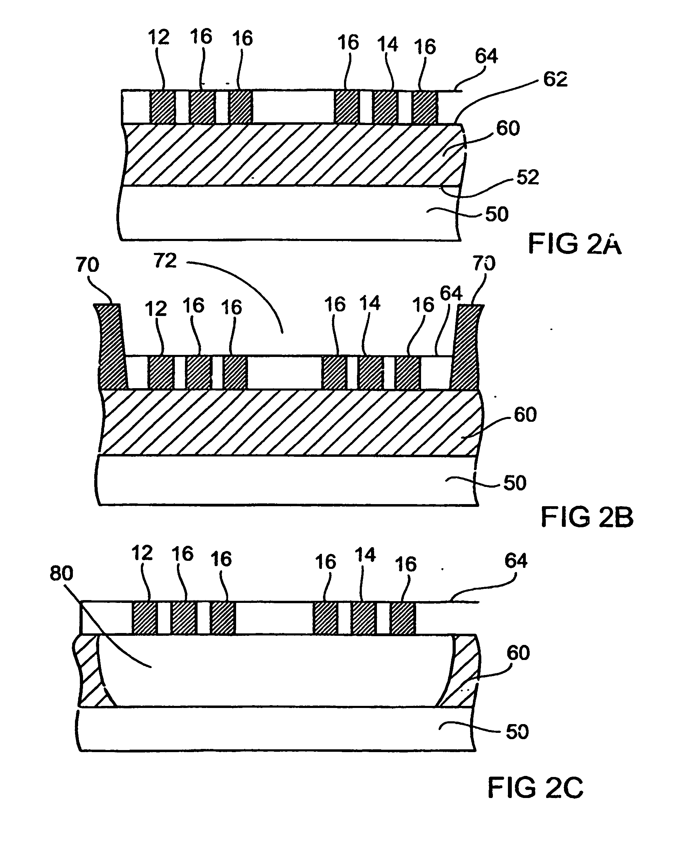

Die Fig. 2A bis 2C zeigen schematische Darstellungen eines vertikalen Schnitts entlang der Linie I-II in Fig. 1 während einer Herstellung einer Spule mit der Spulenleiterbahn 10 über einem Halbleitersubstrat 50.

An einer ersten Oberfläche 52 des Halbleitersubstrats 50 werden zunächst eines oder mehrere nicht dargestellte Bauelemente erzeugt, beispielsweise Dioden oder Transistoren. Zur Verdrahtung der Bauelemente an der Oberfläche 52 des Substrats 50 werden anschließend eine oder mehrere Verdrahtungsschichten über der Oberfläche 52 gebildet. Jede Verdrahtungsschicht besteht aus einer oder mehreren Verdrahtungsleiterbahnen. Jede Verdrahtungsleiterbahn, die nicht direkt auf der Oberfläche 52 des Substrats 50 gebildet ist, ist an einer Oberfläche einer Intermetall-Dielektrikumschicht gebildet, die Verdrahtungsleiterbahnen verschiedener Verdrahtungsschichten elektrisch voneinander isoliert. Zur elektrischen Verbindung zweier Verdrahtungsleiterbahnen in benachbarten Verdrahtungsschichten wird ein Durchgangslochleiter gebildet, der in der dazwischenliegenden IntermetallDielektrikumschicht und senkrecht zu derselben angeordnet ist. Im Sinn einer einfachen und übersichtlichen Darstellung werden die IntermetallDielektrikumschichten über der Oberfläche 52 des Substrats 50 im folgenden summarisch als Dielektrikumschicht 60 bezeichnet und dargestellt, wobei auf eine Darstellung von Verdrahtungsleiterbahnen und Durchgangslochleitern verzichtet wird. Dabei ist es für die vorliegende Erfindung unerheblich, ob die Dielektrikumschicht 60 aus einer oder mehreren IntermetallDielektrikumschichten besteht, und ob sie Verdrahtungsleiterbahnen enthält oder nicht.

Auf einer von dem Substrat 50 abgewandten Oberfläche 62 der Dielektrikumschicht 60 wird schließlich die Spulenleiterbahn 10 gebildet. Es resultiert der in Fig. 2A dargestellte Zustand. Die Linie 64 deutet dabei eine Hintergrundstruktur an.

Anschließend wird eine Maske 70, beispielsweise eine Photolackmaske, auf der Oberfläche 62 der Dielektrikumschicht 60 gebildet, welche im Bereich der Spulenleiterbahn 10 eine Öffnung 72 aufweist. Es resultiert der in Fig. 2B dargestellte Zustand.

Die Öffnung 72 der Maske 70 definiert den Wirkungsbereich eines nachfolgenden Ätzschrittes, wobei alle durch die Maske 70 bedeckten Bereiche der Dielektrikumschicht 60 vor einer Einwirkung des Ätzmediums geschützt sind. In dem Ätzschritt wird mittels einer isotropen Ätzung oder einer Kombination einer anisotropen und einer isotropen Ätzung ein Hohlraum bzw. eine Ausnehmung 80 unter der Spulenleiterbahn 10 erzeugt. Als Ätzverfahren kommen beispielsweise naßchemische Ätzverfahren oder plasmaunterstützte chemische Trockenätzverfahren in Betracht. Dabei erfolgt die Ätzung vorzugsweise selektiv sowohl gegenüber der Maske 70 als auch gegenüber der Spulenleiterbahn 10, d. h. das Ätzverfahren wird so gewählt, daß weder die Maske 70 noch die Spulenleiterbahn 10 in nennenswertem Umfang abgetragen werden. Alternativ besteht auch die Möglichkeit, eine zusätzliche Schicht über der Spulenleiterbahn 10 abzuscheiden, um diese während des Ätzschritts zu schützen. Nach der Erzeugung der Ausnehmung 80 wird die Maske 70 wieder entfernt. Es resultiert der in Fig. 2C dargestellte Zustand.

In einem nachfolgenden Bearbeitungsschritt wird die die Spulenleiterbahn 10 bildende leitfähige, spiralförmige Metallschicht mit einer Passivierungsschicht 84 versehen, die vorzugsweise die gesamte Oberfläche der Spulenleiterbahn 10 bedeckt bzw. die Spulenleiterbahn 10 ummantelt. Die Passivierungsschicht wird vorzugsweise mittels einer plasmaunterstützten Gasphasenabscheidung als Oxid- oder Nitridschicht erzeugt und dient als Korrosionsschutz für die Spulenleiterbahn. Abschließend wird die Passivierungsschicht in den Kontaktierbereichen 20, 36 wieder entfernt, um die Spulenleiterbahn 10 freizulegen und für eine elektrische Kontaktierung zugänglich zu machen.

Um auch nach Bildung der Ausnehmung 80 eine mechanische Verbindung zwischen dem Substrat 50 und der Spulenleiterbahn 10 zu gewährleisten, können beispielsweise die laterale Ausdehnung der Öffnung 72 und damit die resultierende laterale Ausdehnung der Ausnehmung 80 so gewählt werden, daß sich die Ausnehmung 80 nicht unter der gesamten Spulenleiterbahn 10 erstreckt, sondern vielmehr die Dielektrikumschicht 60 unter einem Teil der Spulenleiterbahn 10 erhalten bleibt, beispielsweise unter den Kontaktierbereichen 20, 36 oder den Kreuzungsbereichen 24, 30.

Zur Gewährleistung einer ausreichenden mechanischen Stabilität der Spulenleiterbahn weist diese vorzugsweise ein steifes Material auf.

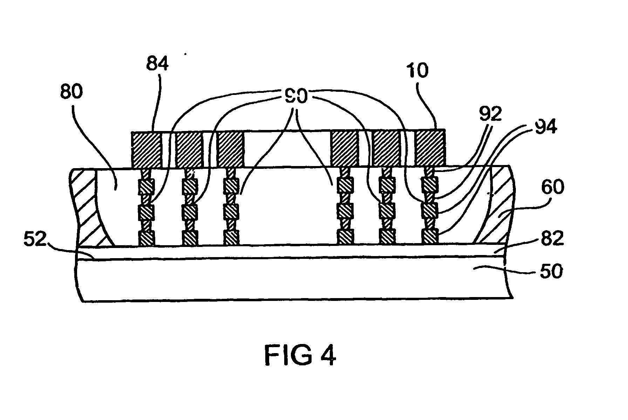

Eine alternatives Ausführungsbeispiel der erfindungsgemäßen Spuleneinrichtung ist in den Fig. 3 und 4 dargestellt. Das Substrat dieser Spuleneinrichtung unterscheidet sich von dem anhand der Fig. 1 und 2 dargestellten dadurch, daß zwischen dem Substrat 50 und der Dielektrikumschicht 60, d. h. auf der Oberfläche 52 des Substrats 50, eine elektrisch isolierende Feldoxidschicht (FOX) vorgesehen ist.

Fig. 3 ist eine schematische Draufsicht des alternativen Ausführungsbeispiels der vorliegenden Erfindung. Die Spulenleiterbahn 10 weist in diesem Ausführungsbeispiel den gleichen Aufbau auf wie in dem in Fig. 1 dargestellten Ausführungsbeispiel. Ein Unterschied besteht jedoch darin, daß bei dem in Fig. 3 dargestellten Ausführungsbeispiel unter der Spulenleiterbahn 10 Stützstellen bzw. Stützeinrichtungen 90 vorgesehen sind, durch die die Spulenleiterbahn 10 mechanisch mit der ganzflächigen Feldoxidschicht verbunden ist.

Fig. 4 ist eine schematische Darstellung eines Schnitts durch die Spulenleiterbahn 10, die von einer Passivierungschicht 84 umgeben ist, und die Stützeinrichtungen 90 entlang der Linie III-IV in Fig. 3. Anders als in dem vorangegangenen Ausführungsbeispiel ist an der Oberfläche 52 des Substrats 50 die ganzflächig aufgebrachte Feldoxidschicht 82 vorgesehen, über der eine Dielektrikumschicht 60 angeordnet ist. Die Spulenleiterbahn 10 ist über einer Ausnehmung 80 in der Dielektrikumschicht 60 angeordnet. In der Schnittdarstellung ist zu erkennen, daß die Stützeinrichtungen 90 in der Ausnehmung 80 so angeordnet sind, daß sie mechanische Verbindungen zwischen dem Substrat 50 bzw. der Feldoxidschicht 82 einerseits und der Spulenleiterbahn 10 andererseits herstellen. Da die Feldoxidschicht 82 ein elektrisch isolierendes Material aufweist, verhindert sie einen elektrischen Kurzschluß zwischen der Spulenleiterbahn 10 und dem Substrat.

Die Stützeinrichtungen 90 werden vorzugsweise bereits bei der Erzeugung der Dielektrikumschicht 60 als Stapel von jeweils übereinander angeordneten Durchgangslochleitern 92 und Verdrahtungsleiterstücken 94 gebildet. Die Durchgangslochleiter 92 und die Verdrahtungsleiterstücke 94 der Stützeinrichtungen 90 werden gemeinsam und gleichzeitig mit nicht dargestellten Durchgangslochleitern und Verdrahtungsleitern, die zur Verdrahtung von Bauelementen in dem Substrat 50 vorgesehen sind, gebildet. Die Bildung der Stützeinrichtungen 90 erfordert somit keinerlei zusätzliche Arbeitsschritte, sondern lediglich eine einfache Modifikation der für die Erzeugung von Durchgangslöchern und Verdrahtungsleitern verwendeten Masken. Dabei sind die die Stützeinrichtungen 90 bildenden Verdrahtungsleiterstücke 94 im einfachsten Falle kleine quadratische oder kreisförmige Inseln.

Die Stützeinrichtungen 90 sind dann notwendig und vorteilhaft, wenn aufgrund der Geometrie der Spulenleiterbahn 10 und/oder aufgrund der mechanischen Eigenschaften der verwendeten Materialien ohne die Stützeinrichtungen 90 eine Verformung der Spulenleiterbahn 10 möglich wäre. Die Stützeinrichtungen 90 verhindern eine Verformung der Spulenleiterbahn 10 zu dem Substrat 50 hin oder von ihm weg aufgrund von elektrostatischen oder magnetischen Kräften oder aufgrund mechanischer Einwirkungen von außen.

Um zu vermeiden, daß die Spulenleiterbahn 10 über eine Stützeinrichtung 90 mit einem Bauelement in dem Substrat 50 kurzgeschlossen wird, ist die Feldoxidschicht 82 vorgesehen. Alternativ wird die Anordnung der Stützeinrichtungen 90 so gewählt werden, daß sie an isolierende oder isolierte Bereiche der Oberfläche 52 des Substrats 50 grenzen. Als eine weitere Alternative wird eine elektrisch isolierende Schicht zwischen der Spulenleiterbahn 10 und den Stützeinrichtungen 90 vorgesehen. Eine Isolierung der Stützeinrichtungen 90 gegenüber der Oberfläche 52 des Substrats 50 liegt auch dann vor, wenn die Ausnehmung 80 in der Dielektrikumschicht 60 eine Tiefe aufweist, die geringer als die Dicke der Dielektrikumschicht 60 ist, wenn also, anders ausgedrückt, ein Rest des Materials der Dielektrikumschicht 60 zwischen der Ausnehmung 80 und der Oberfläche 52 des Substrats 50 stehen bleibt, in dem keine Verdrahtungsleiterstücke 94 und Durchgangslochleiter 92 vorgesehen sind.

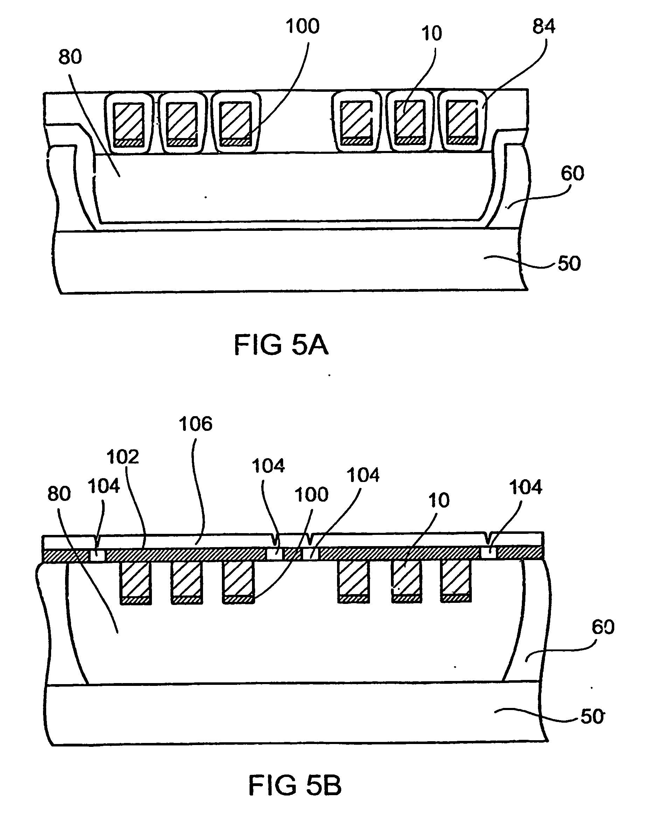

Fig. 5A zeigt eine schematische Darstellung eines Schnitts durch eine Spuleneinrichtung gemäß einem dritten Ausführungsbeispiel. Dieses Ausführungsbeispiel unterscheidet sich von dem ersten Ausführungsbeispiel dadurch, daß unter der Spulenleiterbahn 10 eine Versteifungsschicht 100 vorgesehen ist, die aus einem steiferen Material besteht als die Spulenleiterbahn 10 und zur mechanischen Versteifung und Stabilisierung der Spulenleitebahn vorgesehen ist. Diese Versteifungsschicht ermöglicht eine Verwendung eines weichen Spulenmaterialien und/oder eine Verwendung einer geringeren Anzahl von Stützeinrichtungen 90 und/oder einen Verzicht auf Stützeinrichtungen 90 und/oder einer größeren Ausnehmung 80. Dadurch entstehen zusätzliche Freiheitsgrade bei- Konstruktion und geometrischer Auslegung der Spuleneinrichtung und bei der Auswahl des Materials der Spulenleiterbahn 10.

An dem dritten Ausführungsbeispiel ist ferner eine Passivierungsummantelung bzw. Passivierungsschicht 84 dargestellt, die bereits in Fig. 4 gezeigt ist, hier jedoch eine größere Schichtdicke aufweist.

Fig. 5B zeigt eine schematische Darstellung eines Schnitts durch eine Spuleneinrichtung gemäß einem vierten Ausführungsbeispiel. Dieses Ausführungsbeispiel unterscheidet sich von dem ersten Ausführungsbeispiel dadurch, daß über der Spulenleiterbahn 10 eine Stützschicht 102 vorgesehen ist, die in der Form einer Lochmaske für die Herstellung der Ausnehmung 80 Löcher 104 aufweist, durch die ein Ätzmedium hindurchtreten kann, das die Ausnehmung 80 erzeugt. Die Stützschicht 102 weist eine mechanische Stützfunktion auf und verbessert so die mechanische Stabilität der Spulenleiterbahn 10. Anstelle der die Spulenleiterbahn 10 ummantelnden Passivierungsschicht 84, die in den Fig. 4 und 5A dargestellt ist, ist über der Stützschicht 102 eine Passivierungsschicht 106 vorgesehen, deren Dicke vorzugsweise so gewählt ist, daß die Löcher 104 der Stützschicht 102 durch die Passivierungsschicht 106 geschlossen sind.

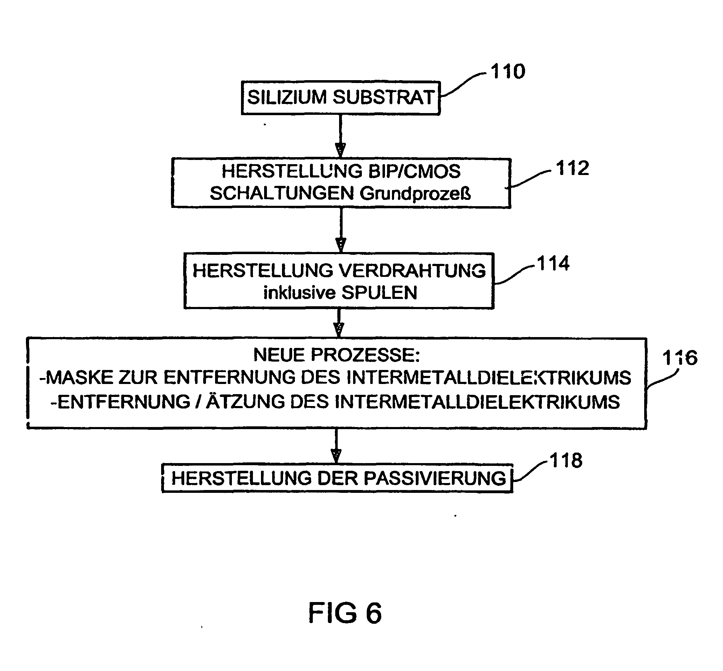

Fig. 6 ist ein vereinfachtes Flußdiagramm, das die Herstellung einer Spuleneinrichtung gemäß der vorliegenden Erfindung darstellt. Ausgangspunkt 110 des Verfahrens ist ein Siliziumsubstrat, an dessen Oberfläche in einem ersten Schritt 112 beispielsweise Bipolar/CMOS-Schaltungen hergestellt werden. Die Bipolar/CMOS-Bauelemente werden in einem zweiten Schritt mittels Verdrahtungsleiterbahnen in einer oder mehreren Verdrahtungsschichten verdrahtet. Gleichzeitig oder anschließend wird in oder, wie oben beschrieben, auf den Verdrahtungsschichten eine Spule (oder mehrere Spulen) erzeugt.

Gemäß der vorliegenden Erfindung wird nun in einem dritten Schritt eine Maske aufgebracht, die einen Bereich an der Spule definiert, in dem die IntermetallDielektrikumschichten in einem Ätzschritt entfernt werden. Nach der Entfernung der Maske wird die Spulenleiterbahn 10 in einem vierten Schritt mit einer Passivierungsschicht versehen.

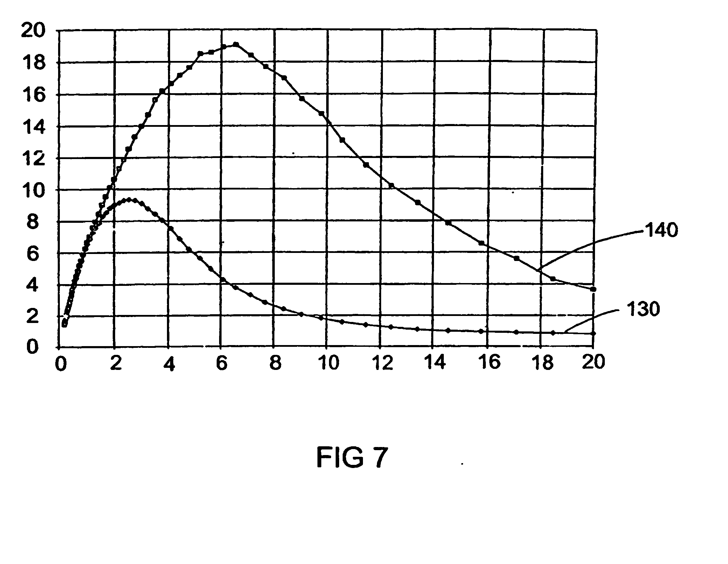

Fig. 7 ist eine schematische Darstellung der Ergebnisse von Messungen der Frequenzabhängigkeit der Güte an einer herkömmlichen Spule und einer Spule gemäß der vorliegenden Erfindung. An der Abszisse ist die Betriebsfrequenz f in GHz aufgetragen, an der Ordinate ist die Güte Q aufgetragen. Eine Kurve 130 zeigt die Frequenzabhängigkeit der Güte der herkömmlichen Spule, eine Kurve 140 zeigt die Frequenzabhängigkeit der Güte der Spule gemäß der vorliegenden Erfindung. Es ist zu erkennen, daß beide Spulen bis zu einer Frequenz f von ca. 1 GHz im wesentlichen die gleiche Güte aufweisen. Während jedoch die Güte der herkömmlichen Spule zwischen 2 GHz und 3 GHz ein Maximum bei ca. Q = 9 aufweist und sich bei höheren Frequenzen rasch einem Wert von Q = 1 nähert, erreicht die Güte der erfindungsgemäßen Spule erst zwischen 6 GHz und 7 GHz ein Maximum, das mit Q = 19 mehr als doppelt so groß ist wie die maximale Güte der herkömmlichen Spule. Bei Frequenzen oberhalb von 7 GHz nimmt auch die Güte Q der erfindungsgemäßen Spule ab, beträgt jedoch auch bei der maximalen dargestellten Frequenz von 20 GHz noch ca. das Vierfache der Güte der herkömmlichen Spule. Die erfindungsgemäße Spule ist folglich bei wesentlich höheren Frequenzen verwendbar als die herkömmliche Spule. Dadurch und aufgrund der doppelt so hohen maximalen Güte erschließen sich der erfindungsgemäßen Spule völlig neue Anwendungsgebiete, für die bisher nur wesentlich aufwendiger hergestellte und teurere Spulen geeignet waren.

In den Ausführungsbeispielen wurde die erfindungsgemäße Spule bzw. Spuleneinrichtung auf einem Siliziumsubstrat beschrieben. Sie ist jedoch ebenso gut auf einem GaAs-Substrat oder einem beliebigen anderen Halbleitersubstrat realisierbar. Ferner muß die Spulenleiterbahn 10 nicht die in den Fig. 1 und 3 gezeigte näherungsweise achteckige Form aufweisen, sondern kann beliebige Formen mit oder ohne Kreuzungsbereichen und eine beliebige Anzahl von Windungen aufweisen. Die Spulenleiterbahn 10 kann ein beliebiges leitfähiges Material aufweisen, wobei Kupfer, Aluminium, Silber und andere Materialien mit hoher spezifischer Leitfähigkeit besonders geeignet sind, um einen geringen elektrischen Widerstand zu erzielen. Anzahl und Anordnung der Stützeinrichtungen 90 sind dabei gegebenenfalls so zu wählen, daß sie eine Verformung der Spulenleiterbahn wirksam verhindern und unter der Spulenleiterbahn am Substrat angeordnete Bauelemente nicht beeinträchtigt werden. Da die effektive oder mittlere Permittivitätszahl ε_{r,eff}, die die Ankopplung der Spule an das Substrat wesentlich beeinflußt, um so geringer ist, je weniger Materie zwischen der Spulenleiterbahn 10 und dem Substrat 50 vorhanden ist, werden die Tiefe und die laterale Ausdehnung der Ausnehmung 80 vorzugsweise möglichst groß gewählt. Aufgrund der in Fig. 7 zu erkennenden hervorragenden Wirkung der Ausnehmung auf die Güte der Spule haben jedoch auch kleinere Ausnehmungen, die nur unter einem Teil der Spulenleiterbahn angeordnet sind, bereits eine deutliche Verbesserung der Güte der Spule zur Folge. Statt einer größeren Ausnehmung können auch zwei oder mehrere kleinere Ausnehmungen vorgesehen werden, wobei zwischen den Ausnehmungen verbleibende Bereiche oder Stege der Dielektrikumschicht 60 die Funktion der Stützeinrichtungen 90 übernehmen können.

Der Hohlraum 80 kann am Ende des Herstellungsverfahrens mit einem Material aufgefüllt werden, das eine deutlich niedrigere Permittivitätszahl aufweist als die Dielektrikumschicht 60. Dadurch wird der Vorteil der verringerten Permittivitätsahl mit dem Vorteil einer hohen mechanischen Stabilität verbunden.

### Bezugszeichenliste

- 10: Spulenleiterbahn
- 12: Abschnitt der Spulenleiterbahn 10
- 14: Abschnitt der Spulenleiterbahn 10
- 16: Abschnitt der Spulenleiterbahn 10
- 12a: erstes Ende des Abschnitts 12
- 14a: erstes Ende des Abschnitts 14
- 16a: erstes Ende des Abschnitts 16
- 12b: zweites Ende des Abschnitts 12
- 14b: zweites Ende des Abschnitts 14
- 16b: zweites Ende des Abschnitts 16
- 20: erster Kontaktierbereich
- 24: erster Kreuzungsbereich
- 26: erstes Verbindungsstück
- 30: zweiter Kreuzungsbereich
- 32: zweites Verbindungsstück
- 36: zweiter Kontaktierbereich
- 40: Inneres der Spulenleiterbahn 10
- 50: Halbleitersubstrat
- 52: Oberfläche des Halbleitersubstrats 50
- 60: Dielektrikumsschicht
- 62: Oberfläche der Dielektrikumsschicht 60
- 64: Hintergrundstruktur
- 70: Maske
- 72: Öffnung in der Maske 70
- 80: Ausnehmung
- 82: Feldoxidschicht
- 84: Passivierungsschicht
- 90: Stützeinrichtung
- 92: Durchgangslochleiter
- 94: Verdrahtungsleiterstück
- 100: Versteifungsschicht
- 102: Stützschicht
- 104: Loch
- 106: Passivierungsschicht
- 110: Ausgangspunkt
- 112: erster Schritt
- 114: zweiter Schritt
- 116: dritter Schritt
- 118: vierter Schritt
- 130, 140: Kurve

## Patentansprüche

1. Spuleneinrichtung mit folgenden Merkmalen:
einer Spulenleiterbahn (10);
einem Halbleitersubstrat (50); und
einer auf dem Halbleitersubstrat (50) angeordneten Dielektrikumschicht (60),
wobei zumindest Teile der Spulenleiterbahn (10) über einer Ausnehmung (80) in der Dielektrikumschicht (60) angeordnet sind,
ferner mit einer Stützeinrichtung (90), die in der Ausnehmung (80) angeordnet und mit der Spulenleiterbahn (10) verbunden ist, zum mechanischen Stützen der Spulenleiterbahn (10), wobei die Stützeinrichtung aus einem Stapel aus übereinander angeordneten Durchgangslochleitern (92) und Verdrahtungsleiterstücken (94) besteht.

2. Spuleneinrichtung gemäß Anspruch 1, ferner mit einer Versteifungsschicht (100), die an einer der Ausnehmung (80) zugewandten Seite der Spulenleiterbahn (10) angeordnet ist.

3. Spuleneinrichtung gemäß Anspruch 1 oder 2, ferner mit einer Stützschicht (102), die an einer von der Ausnehmung (80) abgewandten Seite der Spulenleiterbahn (10) angeordnet ist.

4. Spuleneinrichtung gemäß einem der Ansprüche 1 bis 3, bei der eine Tiefe der Ausnehmung (80) gleich einer Dicke der Dielektrikumschicht (60) ist.

5. Spuleneinrichtung gemäß einem der Ansprüche 1 bis 4, ferner mit einer Passivierungsschicht, die eine Oberfläche der Spulenleiterbahn (10) bedeckt.

6. Spuleneinrichtung gemäß einem der Ansprüche 1 bis 5, wobei die Spuleneinrichtung eine Hochfrequenzspuleneinrichtung ist.

7. Spuleneinrichtung gemäß einem der Ansprüche 1 bis 6, ferner mit einer elektrisch isolierenden Schicht (82), die zwischen dem Halbleitersubstrat (50) und der Dielektrikumschicht (60) angeordnet ist.

8. Verfahren zum Herstellen einer Spule an einem Halbleitersubstrat (50) mit folgenden Schritten:
Erzeugen einer Dielektrikumschicht (60) auf dem Halbleitersubstrat (50);
Erzeugen einer Spulenleiterbahn (10) auf der Dielektrikumschicht (60);
Erzeugen einer Ausnehmung in der Dielektrikumschicht (60) zwischen der Spulenleiterbahn (10) und dem Halbleitersubstrat (50); und
Erzeugen einer Stützeinrichtung (90) vor dem Erzeugen der Spulenleiterbahn (10), so daß die Stützeinrichtung (90) nach dem Erzeugen der Ausnehmung (80) in der Ausnehmung (80) angeordnet und mit der Spulenleiterbahn (10) verbunden ist, zum mechanischen Stützen der Spulenleiterbahn (10), wobei die Stützeinrichtung (90) aus einem Stapel aus übereinander angeordneten Durchgangslochleitern (92) und Verdrahtungsleiterstücken (94) besteht.

9. Verfahren gemäß Anspruch 8, bei dem der Schritt des Erzeugens der Ausnehmung (80) folgende Schritte umfaßt:
Erzeugen einer Maske (70) auf der Dielektrikumschicht (60),
wobei die Maske eine Öffnung (72) aufweist, deren Form eine laterale Form der Ausnehmung (80) bestimmt; und
Entfernen der Dielektrikumschicht (60) im Bereich der Öffnung (72) der Maske (60), um die Ausnehmung (80) zu erhalten.

10. Verfahren gemäß Anspruch 9, bei dem der Schritt des Entfernens einen Schritt des isotropen Ätzens umfaßt.

11. Verfahren gemäß einem der Ansprüche 8 bis 10, ferner mit einem Schritt des Erzeugens einer Passivierungsschicht auf einer Oberfläche der Spulenleiterbahn (10).

12. Verfahren gemäß einem der Ansprüche 8 bis 11, ferner mit einem Schritt des Auffüllens der Ausnehmung (80) mit einem. Material, dessen Permittivitätszahl niedriger ist als die Permittivitätszahl der Dielektrikumschicht (60).

## Claims

1. Coil means, comprising:
a coil trace (10);
a. semiconductor substrate (50); and
a dielectric layer (60) arranged on the semiconductor substrate (50),
wherein at least parts of the coil trace (10) are arranged above a recess (80) in the dielectric layer (60), further comprising a supporting means (90) arranged in the recess (80) and connected to the coil trace (10) for mechanically supporting the coil trace (10), wherein the supporting means (90) comprises a stack of through-hole conductors (92) and wiring conductor pieces (94) arranged on top of each other.

2. Coil means as claimed in claim 1, further comprising a stiffening layer (100) arranged on a side of the coil trace (10) which faces the recess (80).

3. Coil means as claimed in claim 1 or 2, further comprising a supporting layer (102) arranged on a side of the coil trace (10) which faces away from the recess (80).

4. Coil means as claimed in one of claims 1 to 3, wherein a depth of the recess (80) equals a thickness of the dielectric layer (60).

5. Coil means as claimed in one of claims 1 to 4, further comprising a passivation layer covering a surface of the coil trace (10).

6. Coil means as claimed in one of claims 1 to 5, the coil means being a high-frequency coil means.

7. Coil means as claimed in in one of claims 1 to 6, further comprising an electrically insulating layer (82) arranged between the semiconductor substrate (50) and the dielectric layer (60).

8. Method for producing a coil at a semiconductor substrate (50), comprising:
creating a dielectric layer (60) on the semiconductor substrate (50);
creating a coil trace (10) on the dielectric layer (60);
creating a recess in the dielectric layer (60) between the coil trace (10) and the semiconductor substrate (50); and
generating a supporting means (90) prior to creating the coil trace (10), such that, after creating the recess (80). the support means (90) is arranged within the recess (80) and connected to the coil trace (10), for mechanically supporting the coil trace (10), wherein the supporting means (90) comprises a stack of through-hole conductors (92) and wiring conductor pieces (94) arranged on top of each other.

9. Method as claimed in claim 8, wherein the step of creating the recess (80) further comprises:
creating a mask (70) on the dielectric layer (60), the mask comprising an opening (72), the shape of which determines a lateral shape of the recess (80); and
removing the dielectric layer (60) in the area of the opening (72) of the mask (60) to obtain the recess (80).

10. Method as claimed in claim 9, wherein the removing step further comprises a step of isotropic etching.

11. Method as claimed in one of claims 8 to 10, further comprising a step of creating a passivation layer on a surface of the coil trace (10).

12. Method as claimed in one of claims 8 to 11, further comprising a step of filling the recess (80) with a material, the relative permittivity of which is smaller than the relative permittivity of the dielectric layer (60).

## Revendications

1. Dispositif à bobine ayant les caractéristiques suivantes :
une piste (10) conductrice de bobine ;
un substrat (50) semi-conducteur ; et
une couche (60) de diélectrique disposée sur le substrat (50) semi-conducteur,
au moins des parties de la piste (10) conductrice de bobine étant disposées sur un évidement (80) ménagé dans la couche (60) de diélectrique ;
comprenant, en outre, un dispositif (90) d'appui qui est disposé dans l'évidement (80) et qui est relié à la piste (10) conductrice de bobine pour l'appui mécanique de la piste (10) conductrice de bobine, le dispositif d'appui étant constitué d'une pile de conducteurs (92) à trous de passage et de tronçons (84) de conducteur de câblage disposés les uns au dessus des autres.

2. Dispositif à bobine suivant la revendication 1, comprenant, en outre, une couche (100) de renfort qui est disposée d'un côté, tournée vers l'évidement (80), de la piste (10) conductrice de bobine.

3. Dispositif à bobine suivant la revendication 1 ou 2, comprenant, en outre, une couche (102) d'appui qui est disposée d'un côté, éloignée de l'évidement (80), de la piste (10) conductrice de bobine.

4. Dispositif à bobine suivant l'une des revendications 1 à 3, dans lequel une profondeur de l'évidement (80) est égale à une épaisseur de la couche (60) de diélectrique.

5. Dispositif à bobine suivant l'une des revendications 1 à 4, comprenant, en outre, une couche de passivation qui revêt une surface de la piste (10) conductrice de bobine.

6. Dispositif à bobine suivant l'une des revendications 1 à 5, dans lequel le dispositif de bobine est un dispositif de bobine de haute fréquence.

7. Dispositif à bobine suivant l'une des revendications 1 à 6, comprenant, en outre, une couche (82) isolante du point de vue électrique et disposée entre le substrat (50) semi-conducteur et la couche (60) de diélectrique.

8. Procédé de fabrication d'une bobine sur un substrat (50) semi-conducteur comprenant les stades suivants :
production d'une couche (60) de diélectrique sur le substrat (50) semi-conducteur ;
production d'une piste (10) conductrice de bobine sur la couche (60) de diélectrique ;
production d'un évidement dans la couche (60) de diélectrique entre la piste (10) conductrice de bobine et le substrat (50) semi-conducteur ; et
production d'un dispositif (90) d'appui avant la production de la piste (10) conductrice de bobine, de façon à ce que le dispositif (90) d'appui soit disposé, après la production de l'évidement (80), dans l'évidement (80) et soit relié à la piste (10) conductrice de bobine, pour l'appui mécanique de la piste (10) conductrice de bobine, le dispositif (90) d'appui étant constitué d'une pile de conducteurs (92) à trou de passage et de tronçons (94) de conducteur de câblage qui sont disposés les uns au-dessus des autres.

9. Procédé suivant la revendication 8, dans lequel le stade de production de l'évidement (80) comprend les stades suivants :
production d'un masque (70) sur la couche (60) de diélectrique, le masque ayant une ouverture (72) dont la forme définie une forme latérale de l'évidement (80) ; et
élimination de la couche (60) de diélectrique dans la zone de l'ouverture (72) du masque (70) pour obtenir l'évidement (80).

10. Procédé suivant la revendication 9, dans lequel le stade d'élimination comprend un stade d'attaque isotrope.

11. Procédé suivant l'une des revendications 8 à 10, comprenant, en outre, un stade de production d'une couche de passivation sur une surface de la piste (10) conductrice de bobine.

12. Procédé suivant l'une des revendications 8 à 11, comprenant, en outre, un stade de remplissage de l'évidement (80) d'une matière dont l'indice de permittivité est plus petit que l'indice de permittivité de la couche (60) de diélectrique.
